# FASCICULE DE BREVET EUROPEEN

(11) **EP 3 003 973 B1**
(45) Date de publication et mention de la délivrance du brevet: **12.07.2017**
(21) Numéro de dépôt: 14729452.4
(22) Date de dépôt: 27.05.2014
(51) Int. Cl.: C01B 32/16, C01B 32/162, C23C 16/02, C23C 16/26

(54) **SUBSTRAT CONDUCTEUR ELECTRIQUE SUR AU MOINS UNE DE SES FACES MUNI D'UN EMPILEMENT DE COUCHES MINCES POUR LA CROISSANCE DE NANOTUBES DE CARBONE (NTC)**
ELEKTRISCH LEITENDES SUBSTRAT MIT EINEM DÜNNSCHICHTENSTAPEL AUF EINER DER FLÄCHEN DES SUBSTRATS ZUM ZÜCHTEN VON KOHLENSTOFFNANORÖHREN
SUBSTRATE THAT IS ELECTRICALLY CONDUCTIVE ON AT LEAST ONE OF THE FACES OF SAME PROVIDED WITH A STACK OF THIN LAYERS FOR GROWING CARBON NANOTUBES (CNT)

(30) Priorité: 28.05.2013 FR 1354795
(43) Date de publication de la demande: 13.04.2016
(73) Titulaire: Commissariat à l'Energie Atomique et aux Energies Alternatives, 75015 Paris (FR)
(72) Inventeur: OKUNO, Hanako, F-38000 Grenoble (FR); RAMOS, Raphael, F-38100 Grenoble (FR); DIJON, Jean, F-38800 Champagnier (FR)
(74) Mandataire: Nony
(86) Numéro de dépôt international: PCT/IB2014/061749
(87) Numéro de publication internationale: WO 2014/191915

(56) Documents cités:
- WO-A1-2004/000728
- US-A1- 2012 301 663
- SOOKHYUN HWANG ET AL: "Effect of a Titanium Underlayer on the Ohmic Contact of Single-Walled Carbon Nanotubes", CHINESE JOURNAL OF PHYSICS., vol. 49, no. 5, 1 octobre 2011 (2011-10-01), pages 1102-1110, XP055101848, CN ISSN: 0577-9073 cité dans la demande
- NG H T ET AL: "Growth of carbon nanotubes: a combinatorial method to study the effects of catalysts and underlayers", JOURNAL OF PHYSICAL CHEMISTRY. B, MATERIALS, SURFACES, INTERFACES AND BIOPHYSICAL, WASHINGTON, DC, US, vol. 107, no. 33, 21 août 2003 (2003-08-21), pages 8484-8489, XP002450951, ISSN: 1089-5647
- LEE KUEI-YI ET AL: "Vertically aligned growth of carbon nanotubes with long length and high density", JOURNAL OF VACUUM SCIENCE AND TECHNOLOGY: PART B, AVS / AIP, MELVILLE, NEW YORK, NY, US, vol. 23, no. 4, 20 juillet 2005 (2005-07-20), pages 1450-1453, XP012080021, ISSN: 1071-1023, DOI: 10.1116/1.1941187
- GILBERT D NESSIM ET AL: "The Critical Role of the Underlayer Material and Thickness in Growing Vertically Aligned Carbon Nanotubes and Nanofibers on Metallic Substrates by Chemical Vapor Deposition", ADVANCED FUNCTIONAL MATERIALS, WILEY - V C H VERLAG GMBH & CO. KGAA, DE, vol. 20, no. 8, 23 avril 2010 (2010-04-23) , pages 1306-1312, XP001554193, ISSN: 1616-301X, DOI: 10.1002/ADFM.200902265

## Description

### Domaine technique

La présente invention concerne les nanotubes de carbone (NTC).

Elle a trait plus particulièrement à l'amélioration de la croissance catalytique des NTC sur un substrat conducteur électrique sur au moins une de ses faces, en vue d'augmenter la densité des NTC sous forme de tapis et la conduction électrique et avantageusement thermique, entre ces derniers et ladite face du substrat.

Les applications visées par l'invention sont nombreuses et sont celles utilisant les propriétés électriques et/ou thermiques des NTC, parmi lesquelles on peut citer les interconnexions en microélectronique, les électrodes à base de NTC pour piles ou batteries, telles que des batteries au lithium-soufre, ou supercondensateurs, les interposeurs utilisés pour le management thermique en microélectronique, ou les échangeurs thermiques.

Quelques définitions sont données ci-après.

Par « tapis de nanotubes », on entend ici et dans le cadre de l'invention une couche de nanotubes sensiblement parallèles entre eux, orientés perpendiculairement au substrat et dont l'épaisseur est proche de la longueur unitaire des nanotubes.

Par modes de croissance « base growth » et « tip growth », on entend ici et dans le cadre de l'invention, les modes de croissance de NTC largement acceptés dans le domaine, tels que décrits précisément dans la publication [1] au chapitre 8 « *Carbon Nanotube Synthesis and Growth Mechanism*», sous-chapitre 3 « *CNT growth mechanism* »*.*

### Art antérieur

Les NTC ont un fort potentiel pour les applications citées ci-dessus, à condition de pouvoir les faire croître sous forme de tapis denses, i.e. avec des NTC de petit diamètre, sur des substrats conducteurs électriquement sur au moins une de leurs faces, tels que des substrats métalliques ou recouverts d'une ou plusieurs couches de graphéne, et de pouvoir obtenir une bonne conduction électrique, avantageusement thermique, entre les NTC et la face conductrice du substrat.

Plusieurs études portant sur la croissance de NTC sur des substrats ont déjà été réalisées.

Ainsi, pour des applications nanoélectroniques, il est largement connu de faire croitre des NTC à l'aide de catalyseurs métalliques déposés directement sur des substrats semi-conducteurs ou isolants, tels qu'en silicium (Si) ou dioxyde de silicium (SiO₂). Parmi les trois techniques de dépôt connues pour la croissance des NTC que sont l'ablation par arc électrique, l'ablation par laser ou le dépôt chimique en phase vapeur (CVD acronyme anglais pour « *Chemical Vapor Deposition* »), cette dernière est celle la plus prometteuse à l'échelle industrielle pour des raisons de coût.

La publication [2] décrit la croissance de NTC par CVD sur un substrat isolant en SiO₂. Un empilement de trois couches, à savoir respectivement une couche de titane (Ti) de 10 nm d'épaisseur surmontée d'une couche d'aluminium de 10 nm elle-même d'un couche en fer (Fe) de 1 nm d'épaisseur est déposé sur le substrat. Il est indiqué dans cette publication [2] que l'ajout du Ti permet de diminuer la résistance électrique de contact entre les NTC et les électrodes. Seuls des NTC sous forme de monofeuillet (SWNT acronyme anglais de « *Single Walled Nanotubes of Carbon* ») et isolés ont été formés. La croissance des NTC réalisée expérimentalement selon cette publication [2] est donc relativement pauvre avec une densité de NTC faible.

Une seule méthode semble exister à ce jour pour réaliser des tapis denses de NTC électriquement connectés au graphène constituant des substrats. Cette méthode est divulguée dans la publication [3] et est basée sur un mode de croissance dit « inversé ». Il est décrit un empilement de deux couches, à savoir respectivement une couche de catalyseur de croissance de NTC déposée directement sur le graphène et surmontée d'une couche d'alumine (Al₂O₃). Typiquement, l'empilement est constitué d'une couche de Fe de 1nm d'épaisseur surmontée d'une couche d'Al₂O₃ de 3 nm d'épaisseur. L'inconvénient principal de cette méthode est lié au mode de croissance utilisé qui ne produit pas des tapis de NTC denses.

En ce qui concerne la croissance de NTC sur des substrats métalliques, de nombreuses études ont été publiées: on pourra se reporter à la publication [1], chapitre 6 « *Direct Growth of Carbon Nanotubes on Metal Supports by Chemical Vapor Deposition* » qui est une synthèse de ces études.

Il ressort des études avant tout qu'il est difficile de faire pousser des tapis de NTC sur des métaux, puisque les températures élevées nécessaires pour le dépôt par CVD font diffuser le catalyseur de croissance dans le métal du substrat, qui devient alors ineffectif. C'est pourquoi, il s'avère nécessaire d'utiliser une barrière pour empêcher cette diffusion, mais ces barrières sont la plupart du temps isolantes à la fois électriquement et thermiquement. Autrement dit, ces barrières isolantes affectent la conductivité électrique entre substrats métalliques et NTC.

Il est connu essentiellement deux types de couches-barrières conductrices pour la croissance de tapis de NTC, à savoir une couche en nitrure de titane (TiN) et une couche en aluminium (Al).

Il a pu être constaté qu'avec une couche-barrière en TiN, la croissance des NTC s'effectue généralement dans le mode « *tip growth* » et que l'on obtient des tapis peu denses de relativement gros NTC.

A l'inverse, avec une couche-barrière en Al, il a été constaté qu'on obtient un mode de croissance « *base growth* » favorable à la croissance de tapis denses de petits NTC. L'inconvénient majeur est que la conductivité électrique est relativement mauvaise entre le substrat métallique et les NTC, puisque l'aluminium se retrouve sous forme oxydée après croissance des NTC.

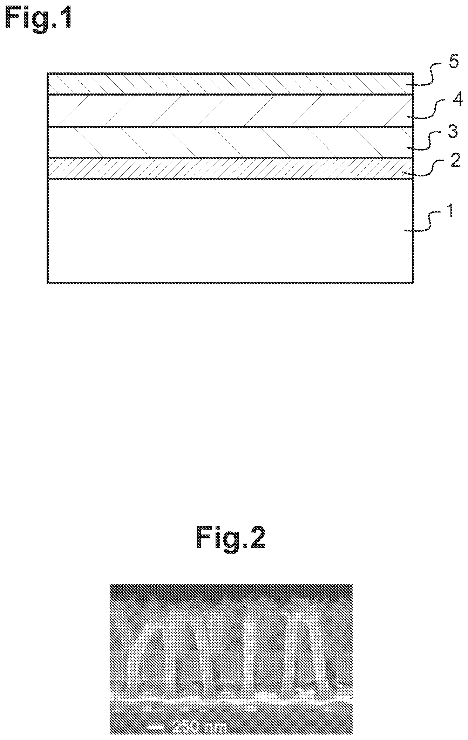

La publication [4] décrit une telle couche-barrière en Al surmontée d'une couche en Fe en tant que catalyseur de croissance. De cette publication [4], il ressort qu'il est nécessaire d'avoir une couche en Al suffisamment épaisse, typiquement d'épaisseur supérieure à 3,5 nm pour obtenir une croissance adéquate : il est montré à contrario qu'avec une couche en Al de 2 nm d'épaisseur seulement, la qualité du tapis de NTC est dégradée (voir la figure 2f).

Le document WO2004/000728 A1 décrit un substrat destiné à la croissance de nanotubes de NTC, comprenant une première couche électro-conductrice sur un substrat de silicium, où le premier élément électro-conducteur est formé d'un élément choisi dans le groupe constitué par Ti, Ni, Al et Cr, une seconde couche électro-conductrice sur la première couche électro-conductrice, la seconde couche électro-conductrice étant formée d'un élément choisi dans un groupe constitué par W, Mo et Ta, et enfin une couche catalytique incluant un métal ou un alliage qui sert de catalyseur pour développer un nanotube en carbone sur la seconde couche électro-conductrice. Par conséquent, il a été le plus souvent envisagé des couches-barrières en Al de 10 à 20 nm d'épaisseur. Après croissance des NTC, une couche de 10 à 20 nm d'aluminium oxydée est donc présente entre le substrat métallique et le tapis de NTC, ce qui implique une faible conductivité électrique.

Il existe donc un besoin pour améliorer la croissance de NTC sous forme de tapis sur des substrats électriquement conducteurs sur au moins une de leurs faces, tels que des substrats métalliques ou revêtus de graphène, notamment en vue d'augmenter la densité des tapis de NTC et d'augmenter la conductivité électrique, avantageusement thermique entre ces derniers et lesdites faces conductrices des substrats.

Le but de l'invention est de répondre au moins en partie à ce besoin.

### Exposé de l'invention

Pour ce faire, l'invention concerne, sous l'un de ses aspects, un substrat électriquement conducteur sur au moins une de ses faces, muni d'un empilement de couches minces comportant au moins une couche de matériau catalyseur adapté pour accélérer la croissance des nanotubes de carbone, caractérisé en ce que l'empilement comporte la séquence de couches minces déposées dans l'ordre suivant au-dessus de ladite au moins une face électriquement conductrice du substrat :
a/ le cas échéant, couche métallique en métal M ou couche en alliage métallique à base du métal M ou couche en graphène;
b/ couche de titane (Ti) ;
c/ couche d'aluminium (Al) ;
d/ couche de matériau(x) catalyseur(s) de la croissance de nanotubes de carbone.

Autrement dit, l'invention consiste à réaliser sur au moins la face électriquement conductrice d'un substrat un empilement à au moins trois couches conductrices afin d'une part de faire croitre des tapis denses de petits NTC, typiquement de diamètre unitaire inférieur à 10 nm, et d'autre part d'assurer une bonne conduction électrique et thermique entre les NTC et la face conductrice du substrat.

Les tapis denses de petits NTC obtenus sont sous forme de multi feuillets, aussi appelés MWNT (acronyme anglais pour « *Multi Walled Carbon Nanotubes* »).

La couche métallique en métal M ou couche en alliage métallique à base du métal M ou couche en graphène est optionnelle car lorsque le substrat est en acier inoxydable (inox), aucun oxyde natif n'est formé. Il n'y a donc pas d'alliage nuisible à la conductivité électrique qui est formé dans la gamme de température envisagée pour la croissance de NTC par CVD

Lorsqu'elle est présente, la couche métallique M joue différents rôles en fonction de la nature du substrat sous-jacent. Plusieurs cas sont donc à distinguer pour permettre le choix de la nature et l'épaisseur de la couche en métal M. Elle doit notamment permettre d'empêcher la diffusion du Ti dans le substrat sous-jacent et d'empêcher la formation d'un alliage entre le Ti et le substrat sous-jacent. On choisit ainsi une couche fine d'un métal diffusant peu dans le substrat et dans le Ti ou une couche plus épaisse d'un métal pouvant diffuser dans le substrat. Dans le cas où le substrat est un métal se passivant rapidement, comme l'aluminium, la fonction de la couche M est avantageusement en outre d'augmenter la conductivité de l'oxyde natif de surface. On choisit alors une couche fine d'un métal pouvant diffuser dans l'oxyde correspondant.

La bicouche mince Al/Ti a plusieurs fonctions dans le cadre de l'invention. Elle permet tout d'abord le démouillage du catalyseur et la croissance de NTC selon le mode « base growth » assurant ainsi la croissance de tapis dense de NTC de petits diamètres unitaires, typiquement inférieurs à 10nm. Elle a également le rôle d'une barrière, à la fois barrière à la diffusion du catalyseur, et surtout de barrière à l'oxydation. Elle permet ainsi de contrôler et réduire l'épaisseur de la couche oxydée se formant le cas échéant pendant la croissance des NTC. Au final, elle permet donc l'obtention d'une excellente conductivité électrique de l'interface.

Les inventeurs ont pu prouver que l'empilement de couches minces selon l'invention consistant en au moins Al/Ti/Fe permet la croissance de tapis denses de petits NTC sur des substrats soit métalliques, soit revêtus de graphène et ce quelle que soit la nature du substrat-support du graphène tout en assurant une bonne conduction électrique et thermique entre les NTC et le substrat.

Selon un mode de réalisation avantageux, le substrat peut être un substrat métallique massif. Le métal du substrat peut alors être choisi avantageusement parmi le cuivre (Cu), l'aluminium (Al), l'acier inoxydable, le nickel (Ni), le platine (Pt).

Selon un autre mode de réalisation avantageux, le substrat peut être un substrat revêtu d'une ou plusieurs couches minces électriquement conductrices formant ladite face électro-conductrice. La(les) couche(s) mince(s) électriquement conductrice(s) peu(ven)t être alors avantageusement choisie(s) parmi le nitrure de titane (TiN), le nitrure de tantale (TaN), le graphène.

Le substrat revêtu peut être avantageusement un substrat électriquement isolant, tel qu'en silicium (Si) ou en dioxyde de silicium (SiO2).

De préférence, le métal M de la couche métallique déposée directement sur la face électriquement conductrice du substrat est choisi parmi le fer (Fe), le chrome (Cr), le nickel (Ni), le cobalt (Co), le palladium (Pd), ainsi que parmi tous les alliages binaires, ternaires ou quaternaires entre ces métaux.

De préférence également, le(s) matériau(x) catalyseur(s) de la croissance des nanotubes de carbone (NTC) de la couche du dessus de l'empilement est (sont) choisi(s) parmi le fer (Fe), le chrome (Cr), le nickel (Ni), le cobalt (Co), le palladium (Pd), ainsi que parmi tous les alliages binaires, ternaires ou quaternaires entre ces métaux.

Selon une variante avantageuse, la couche déposée directement sur la face électriquement conductrice du substrat et la couche de matériau catalyseur de la croissance de nanotubes de carbone sont constituées du même matériau. Cela a pour avantage de simplifier le procédé de dépôt des couches minces, notamment par évaporation sous vide dans le même cycle de vide.

L'épaisseur de la couche déposée directement sur la face électriquement conductrice du substrat est de préférence comprise entre 1 et 20 nm.

L'épaisseur de la couche de Ti est de préférence comprise entre 2 et 10 nm.

L'épaisseur de la couche d'Al est de préférence comprise entre 2 et 10 nm.

L'épaisseur de la couche de matériau(x) catalyseur(s) de la croissance de nanotubes de carbone est de préférence comprise entre 0,2 et 5 nm, de préférence encore entre 0,25 et 2 nm.

L'empilement peut être le suivant : substrat massif en cuivre ou en aluminium/Fe/Ti/Al/Fe, la couche de fer (Fe) directement en contact avec le substrat massif étant d'épaisseur comprise entre 1 et 10 nm.

L'empilement peut également être le suivant : substrat massif en acier inoxydable/Ti/Al/Fe.

L'empilement peut également être le suivant : substrat en nitrure de titane (TiN) ou nitrure de tantale (TaN) sous forme de couches minces/Fe/Ti/Al/Fe, la couche de fer (Fe) directement en contact avec le substrat étant d'épaisseur comprise entre 10 et 20 nm.

L'empilement peut également être le suivant : substrat massif recouvert d'une ou plusieurs couches en graphène/Fe/Ti/Al/Fe, la couche de fer (Fe) directement en contact avec le graphène étant d'épaisseur comprise entre 1 et 10 nm.

L'invention a également pour objet selon un autre de ses aspects un substrat fonctionnel comportant un substrat qui vient d'être décrit, revêtu d'un tapis de nanotubes de carbone (NTC). Dans un tel substrat, la densité de NTC est avantageusement supérieure à 10¹²/cm², voire 10¹³/cm².

L'invention a également pour objet selon encore un autre de ses aspects, un procédé de réalisation d'un substrat fonctionnel qui vient d'être décrit, selon lequel on réalise les étapes suivantes :
- réalisation de l'empilement de couches minces, avec le cas échéant la couche métallique en métal M ou couche en alliage métallique à base du métal M ou couche en graphène, sur la face électriquement conductrice du substrat décrit ci-avant par évaporation sous vide ;
- croissance de tapis de nanotubes de carbone (NTC) sur l'empilement selon une technique de dépôt chimique en phase vapeur (acronyme anglais CVD de « *Chemical Vapor Deposition* »), assistée ou non par plasma et activée par filaments chauds (acronyme anglais HFCVD pour « *Hot Wire* (*CVD* ») ou non.

Selon une variante avantageuse, avant d'effectuer l'étape de croissance, on effectue une oxydation de la couche de matériau(x) catalyseur(s) au moyen d'un plasma d'air.

L'invention a enfin pour objet l'utilisation d'un substrat fonctionnel décrit ci-avant en tant qu'élément d'interconnexion en microélectronique, ou d'électrodes pour piles ou batteries, telles que des batteries au lithium-soufre, ou de supercondensateurs, d'interposeurs utilisés pour le management thermique en microélectronique, ou d'échangeurs thermiques.

### Description détaillée

D'autres avantages et caractéristiques de l'invention ressortiront mieux à la lecture de la description détaillée d'exemples de mise en oeuvre de l'invention faite à titre illustratif et non limitatif en référence aux figures suivantes parmi lesquelles :
- la figure 1 est une vue schématique en coupe transversale d'un substrat revêtu d'un empilement de couches minces selon l'invention ;
- la figure 2 est une image faite par un microscope à balayage électronique (MEB) d'un tapis dense de NTC sur un substrat en aluminium obtenu par une technique CVD conformément à l'invention,
- la figure 3A est une image prise par MEB d'un tapis dense de NTC sur un substrat en aluminium obtenu par une technique CVD activée par filaments chauds (HFCVD) conformément à l'invention,
- la figure 3B est une image prise par microscopie électronique en transmission (MET ou TEM en anglais pour *Transmission Electron Microscopy*) d'un NTC sur un substrat en aluminium obtenu par une technique CVD activée par filaments chauds (HFCVD) conformément à l'invention,
- la figure 4 est une vue schématique en coupe transversale d'un substrat en inox revêtu d'un empilement de couches minces selon l'invention,
- les figures 5A et 5B sont des images prises, respectivement à 45° et en coupe, par MEB d'un tapis dense de NTC sur un substrat en nickel supportant un empilement de couches de graphène, conformément à l'invention,
- les figures 6A à 6C sont des images prise à 45° par MEB d'un tapis dense de NTC sur un substrat en SiO₂ supportant respectivement une, deux et trois couches de graphène, conformément à l'invention,
- la figure 6D est une image prise par MET d'un NTC sur un substrat en en SiO₂ supportant au moins une couche de graphène, conformément à l'invention.

On précise ici que par souci les différentes proportions entre les épaisseurs de matériaux n'ont pas été respectées.

On précise que l'unité de débit indiquée ci-après sous l'acronyme anglais sccm pour « *standard cubic centimeters per minute* », correspond à l'unité d'un débit d'un centimètre cube par minute dans les conditions de température à 0°C de pression à 101,325 kPa.

On précise que les exemples 1 à 6 sont réalisés conformément à l'invention et que les exemples réalisés selon l'état de l'art et donnés à titre d'exemples comparatifs ne sont pas référencés, mais explicités chacun à la fin de la description d'un exemple conforme à l'invention.

Dans tous ces exemples, les dépôts successifs des couches minces 3, 4, 5 et éventuellement 2 sur le substrat 1 ont été réalisés selon une technique d'évaporation sous vide dans un même cycle de vide. Bien évidemment, dans le cadre de l'invention, ils peuvent être réalisés par toute autre technique permettant une bonne maîtrise des épaisseurs de couches obtenues.

### Exemple 1:

Cet exemple 1 concerne la croissance de tapis denses de NTC sur un substrat 1 d'aluminium (Al). Dans cet exemple 1, le substrat peut être réalisé sous forme de couche(s) mince(s) ou être constitué d'un matériau massif en Al. L'aluminium se passivant très rapidement à l'air, la couche mince 2 est constituée d'une couche fine d'un métal M pouvant diffuser dans l'oxyde d'aluminium, avantageusement le fer.

Les étapes du procédé de réalisation d'un tapis dense de NTC sont les suivantes :
Etape 1/ : On réalise une désoxydation du substrat 1 en Al, dans un bain de HF dilué à 0,1%, pendant une durée de 30s.
Etape 2/ : On réalise ensuite les dépôts successifs des couches minces 2, 3, 4, 5 sur le substrat 1 en Al. Ainsi, après dépôt de l'empilement, comme montré sur la figure 1, le substrat 1 est surmonté respectivement d'une couche 2 en fer, d'une couche 3 de titane, puis d'une couche 4 en aluminium, et enfin d'une couche 5 en fer en tant que catalyseur.
L'empilement est donc du type substrat en Al/Fe/Ti/Al/Fe.
Le tableau 1 ci-dessous indique l'épaisseur en nanomètres (nm) de chacune des couches minces de l'empilement sur le substrat 1 en Al.

**TABLEAU 1**

| COUCHE MINCE | EPAISSEUR |
|---|---|
| Fe (2) | 1-10 nm, de préférence égale à 2nm |
| Ti (3) | 5nm |
| Al (4) | inférieure à 5 nm, de préférence égale à 2nm |
| Fe (5) | 1 nm |

Etape 3/ : On effectue la croissance d'un tapis de NTC par une technique de dépôt chimique en phase vapeur (CVD acronyme anglais de « *Chemical Vapor Deposition* ») à 600°C en utilisant un mélange gazeux de C₂H₂ / H₂ / He introduit dans le réacteur CVD dans les débits respectifs suivantes : 15 sccm / 50 sccm / 110 sccm.

Les autres conditions du dépôt CVD sont les suivantes :
- pression du mélange gazeux à 0,3 Torr ;
- temps de montée entre l'ambiante et 600°C : 15 minutes ;
- durée de croissance de 10minutes à 1heure suivant la hauteur de tapis NTC désirée.

On précise ici, que cette croissance a été effectuée, après avoir préalablement oxydé la couche 5 de catalyseur, au moyen d'un plasma RF capacitif d'air de puissance 70 W, à une pression de 0,3 Torr et pendant une durée de 30 min.

Selon une application avantageuse de cet exemple 1, la croissance des NTC peut être réalisée dans des vias de 250 nm de diamètre et destinés à déboucher sur des lignes en Al afin de réaliser des interconnexions en microélectronique : la figure 2 illustre clairement cette croissance des NTC à travers les vias.

L'exemple 1 selon l'invention qui vient d'être décrit permet d'obtenir des tapis de NTC avec des densités dépassant 10¹² /cm².

En outre, la conduction électrique entre un tapis 6 de NTC et le substrat 1 d'Al obtenue selon cet exemple 1 est largement augmentée par rapport à l'état de l'art. En particulier, la résistance spécifique de contact obtenue entre le substrat 1 d'Al et un tapis 6 de NTC selon l'invention est inférieure 3x10⁻⁸ Ω.cm⁻².

Ainsi, à titre d'exemple comparatif, la conduction électrique obtenue selon cet exemple 1 de l'invention est augmentée d'un facteur au moins égal à 3 par rapport à un substrat en Al soit surmonté directement uniquement d'une couche de 1nm de Fe, soit surmonté d'une couche de 10 nm en Al elle-même surmontée d'une couche de 1nm de Fe (empilement : substrat en Al/Al/Fe).

### Exemple 2:

Les étapes 1/ et 2/ de l'exemple 1 sont reproduites à l'identique. Seule l'étape 3/ de croissance des NTC est modifiée de la manière suivante :
- aucune oxydation préalable de la couche 5 de catalyseur (1nm de Fe) ;
- dépôt CVD activé par filaments chauds également connue sous l'acronyme anglais de HFCVD pour « *Hot Filament Chemical Vapor Deposition* ».

On précise que le mélange gazeux est identique à celui de l'exemple 1 avec les mêmes débits, que la température du dépôt HFCVD est aux environs de 450°C et que la puissance de filaments chauds appliquée est de l'ordre de 450 W.

L'exemple 2 selon l'invention qui vient d'être décrit permet d'obtenir des tapis de NTC sous forme MWNT, ayant un diamètre unitaire moyen de 6 nm, avec en moyenne un nombre de six parois par NTC. La densité de parois de NTC obtenue est supérieure à 10¹³/cm².

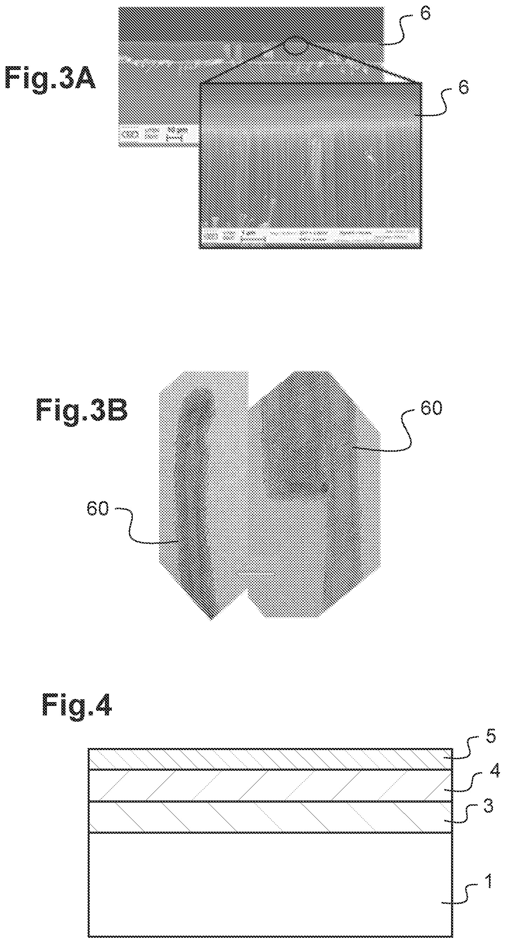

La figure 3A montre un tapis 6 de NTC 60 sous forme MWNT obtenus selon l'exemple 2 de l'invention, tandis que la figure 3B montre en détail la structure d'un NTC obtenu également selon cet exemple 2.

En outre, la conduction électrique entre un tapis 6 de NTC et le substrat 1 d'Al obtenue selon cet exemple 2 est largement augmentée par rapport à l'état de l'art.

Ainsi, à titre d'exemple comparatif, la conduction électrique obtenue selon cet exemple 2 de l'invention est augmentée d'un facteur 10 à 100 par rapport à un substrat en Al surmonté directement uniquement d'une couche de 1nm de Fe et dont la croissance de NTC a également été activée par filaments chauds (HFCVD).

### Exemple 3:

Cet exemple 3 concerne la croissance de tapis denses de NTC sur un substrat 1 de cuivre (Cu). Dans cet exemple 3, le substrat peut être réalisé sous forme de couche(s) mince(s) ou être constitué d'un matériau massif en Cu. Le titane ayant la capacité de diffuser facilement dans le cuivre, la couche mince 2 est constituée d'une couche fine d'un métal M, avantageusement le fer, permettant d'empêcher ce phénomène de diffusion.

Les étapes du procédé de réalisation d'un tapis dense de NTC sont les suivantes :
Etape 1/ : On réalise ensuite les dépôts successifs des couches minces 2, 3, 4, 5 sur le substrat 1 en Cu. Ainsi, après dépôt de l'empilement, comme montré sur la figure 1, le substrat 1 est surmonté respectivement d'une couche 2 en fer, d'une couche 3 de titane, puis d'une couche 4 en aluminium, et enfin d'une couche 5 en fer en tant que catalyseur.

L'empilement est donc du type substrat en Cu/Fe/Ti/Al/Fe.

Le tableau 2 ci-dessous indique l'épaisseur en nanomètres (nm) de chacune des couches minces de l'empilement sur le substrat 1 en Cu.

**TABLEAU 2**

| COUCHE MINCE | EPAISSEUR |
|---|---|
| Fe (2) | 1-10 nm, de préférence égale à 2nm |
| Ti (3) | 5nm |
| Al (4) | inférieure à 5 nm, de préférence égale à 2nm |
| Fe (5) | 1 nm |

L'empilement de couches 2 à 5 et les épaisseurs correspondantes sont donc identiques à ceux des exemples 1 et 2.

Etape 2/ : On effectue la croissance d'un tapis de NTC selon la même technique avec les mêmes conditions que pour l'exemple 1.

L'exemple 3 selon l'invention qui vient d'être décrit permet d'obtenir des tapis de NTC avec croissance sur Cu selon un mode « *base growth* ».

Ainsi, le mode de croissance des NTC selon cet exemple 3 de l'invention est bien meilleur que celui dit de type « tip growth » observé selon l'état de l'art sur un substrat en Cu, en particulier lorsqu'on utilise en tant que couche barrière une couche mince de nitrure de titane (TiN) qui conduit à une croissance en mode « tip growth » et donc à des tapis de NTC de faibles densité.

De façon alternative, la couche 2 de Fe directement déposée sur le cuivre peut être remplacée par une couche de Cr, de Ni, de Co ou de Pd d'épaisseur similaire ou une couche de graphène.

Cet exemple 3 selon l'invention peut être appliqué de la même manière à un substrat en nickel (Ni) en lieu et place d'un substrat en cuivre.

### Exemple 4:

Cet exemple 4 concerne la croissance de tapis denses de NTC sur un substrat 1 de TiN sous forme de couche(s) mince(s). En raison de la structure colonnaire du TiN en couche mince, la plupart des métaux diffusent fortement dans le TiN. Ainsi, la couche mince 2 est ici constituée d'une couche fine d'un métal M, avantageusement le fer, relativement épaisse, de préférence une couche de 10 à 20 nm.

Les étapes du procédé de réalisation d'un tapis dense de NTC sont les suivantes :
Etape 1/ : On réalise ensuite les dépôts successifs des couches minces 2, 3, 4, 5 sur le substrat 1 en TiN. Ainsi, après dépôt de l'empilement, comme montré sur la figure 1, le substrat 1 est surmonté respectivement d'une couche 2 en fer, d'une couche 3 de titane, puis d'une couche 4 en aluminium, et enfin d'une couche 5 en fer en tant que catalyseur.
L'empilement est donc du type substrat en TiN/Fe/Ti/Al/Fe.
Le tableau 3 ci-dessous indique l'épaisseur en nanomètres (nm) de chacune des couches minces de l'empilement sur le substrat 1 en TiN.

**TABLEAU 3**

| COUCHE MINCE | EPAISSEUR |
|---|---|
| Fe (2) | 10-20 nm, de préférence égale à 20nm |
| Ti (3) | 5nm |
| Al (4) | inférieure à 5 nm, de préférence égale à 2nm |
| Fe (5) | 1 nm |

Etape 2/ : On effectue la croissance d'un tapis de NTC selon la même technique avec les mêmes conditions que pour les exemples 1 et 3.

L'exemple 4 selon l'invention qui vient d'être décrit permet d'obtenir des tapis de NTC avec croissance sur TiN selon un mode « *base growth* »*.*

De façon alternative, la couche 2 de Fe déposée directement sur TiN peut être remplacée par une couche de Cr, de Ni ou de Co d'épaisseur similaire.

Cet exemple 4 selon l'invention peut être appliqué de la même manière à un substrat en nitrure de tantale (TaN) en lieu et place d'un substrat en TiN.

### Exemple 5:

Cet exemple 5 concerne la croissance de tapis denses de NTC sur un substrat 1 d'acier inoxydable (inox) sous forme d'un matériau massif. L'inox est un matériau qui ne forme pas d'oxyde natif et dans lequel le titane diffuse peu et ne forme pas d'alliage dans la gamme de température envisagée pour la croissance de NTC par CVD. Il est envisageable de supprimer ici la couche mince 2.

Les étapes du procédé de réalisation d'un tapis dense de NTC sont les suivantes :
Etape 1/ : On réalise ensuite les dépôts successifs des couches minces 3, 4, 5 sur le substrat 1 en inox. Ainsi, après dépôt de l'empilement, comme montré sur la figure 4, le substrat 1 est surmonté respectivement d'une couche 3 de titane, puis d'une couche 4 en aluminium, et enfin d'une couche 5 en fer en tant que catalyseur.
L'empilement est donc du type substrat en inox/Ti/Al/Fe.
Le tableau 4 ci-dessous indique l'épaisseur en nanomètres (nm) de chacune des couches minces de l'empilement sur le substrat 1 en inox.

**TABLEAU 4**

| COUCHE MINCE | EPAISSEUR |
|---|---|
| Ti (3) | 5nm |
| Al (4) | inférieure à 5 nm, de préférence égale à 2nm |
| Fe (5) | 1 nm |

Etape 2/ : On effectue la croissance d'un tapis de NTC selon la même technique avec les mêmes conditions que pour les exemples 1, 3 et 4.

L'exemple 3 selon l'invention qui vient d'être décrit permet d'obtenir des tapis de NTC avec croissance sur l'acier inoxydable selon un mode « *base growth* ».

En outre, la conduction électrique à l'interface entre un tapis 6 de NTC et le substrat 1 en acier inox obtenue selon cet exemple 5 est bonne.

### Exemple 6:

Cet exemple 6 concerne la croissance de tapis denses de NTC sur un substrat 1 dont au moins une face est en graphène.

Le substrat 1 supportant la face en graphène peut être métallique, tel que du Cu, Ni ou Pt. Il peut être également en matériau isolant électrique tel qu'en silicium (Si) ou en dioxyde de silicium (SiO₂).

Le substrat 1 peut supporter une ou plusieurs couches de graphène constituant une face électriquement conductrice. Ainsi, il peut s'agir d'une unique couche de graphène, d'un empilement de plusieurs couches de graphène jusqu'à du graphène produit par exfoliation de graphite pyrolitique hautement orienté (HOPG acronyme anglais de «*highly orientated pyrolytic graphite*»)*.*

La couche mince 2 est constituée d'une couche fine d'un métal M, avantageusement en fer, permettant d'éviter la formation d'alliage de type carbure de titane entre le graphène et le titane de la couche 3.

Les étapes du procédé de réalisation d'un tapis dense de NTC sont les suivantes :
Etape 1/ : On réalise ensuite les dépôts successifs des couches minces 2, 3, 4, 5 sur le substrat supportant au moins une couche de graphène formant une face électriquement conductrice. Ainsi, après dépôt de l'empilement, comme montré sur la figure 1, la face de graphène 1 est surmontée respectivement d'une couche 2 en fer, d'une couche 3 de titane, puis d'une couche 4 en aluminium, et enfin d'une couche 5 en fer en tant que catalyseur.
   L'empilement est donc du type substrat avec face en graphène/Fe/Ti/Al/Fe.
   L'empilement de couches 2 à 5 et les épaisseurs correspondantes sont identiques à ceux des exemples 1 à 3.
Etape 2/ : On effectue la croissance d'un tapis de NTC selon la même technique de dépôt CVD activé par filaments chauds avec les mêmes conditions de température, mélange gazeux avec les débits respectifs que pour l'exemple 2.

Les autres conditions du dépôt CVD sont les suivantes :
- pression du mélange gazeux à 0,3 Torr ;
- temps de montée entre l'ambiante et 450°C : 12 minutes ;
- durée de croissance de 10 à 30 minutes suivant la hauteur de tapis NTC désirée.

L'exemple 6 selon l'invention avec un substrat en nickel supportant un empilement de couches de graphène permet d'obtenir des tapis de NTC avec des densités dépassant 10¹²/cm².

En outre, la conduction électrique entre un tapis 6 de NTC et le substrat en Ni supportant un empilement de couches de graphène obtenue selon cet exemple 6 est largement augmentée par rapport à l'état de l'art et est tout à fait comparable à celle obtenue entre le tapis 6 de NTC et le substrat 1 en Al de l'exemple 1 selon l'invention.

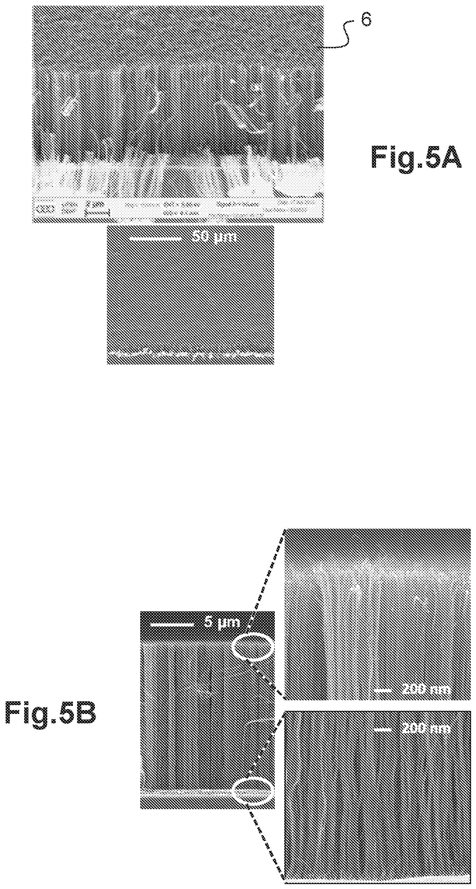

Les figures 5A et 5B montrent un tapis 6 de NTC 60 sous forme MWNT obtenus selon l'exemple 6 de l'invention avec un substrat en nickel supportant un empilement de couches de graphène.

L'exemple 6 selon l'invention avec un substrat en SiO₂ sur lequel est(sont) transférée(s) une ou plusieurs couches de graphène permet d'obtenir des tapis de NTC sous forme MWNT, ayant un diamètre unitaire moyen de 5 nm, avec en moyenne un nombre de deux ou trois parois par NTC. La densité de parois de NTC obtenue est supérieure à 10¹²/cm².

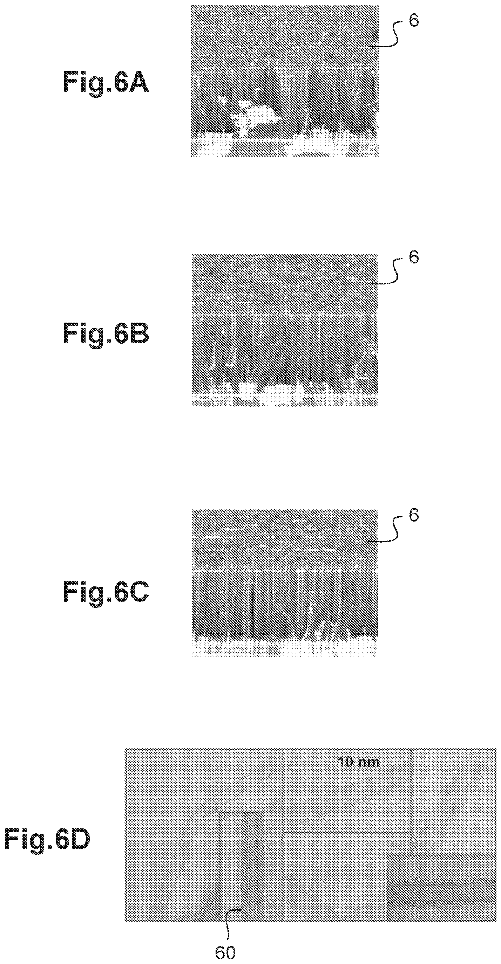

Les figures 6A à 6C montrent un tapis 6 de NTC 60 sous forme MWNT obtenus selon l'exemple 6 de l'invention avec un substrat en SiO₂ supportant respectivement une couche, deux couches ou trois couches de graphène.

La figure 6D montre en détail un NTC obtenu selon cet exemple 6 avec un substrat en SiO₂ supportant au moins une couche de graphène.

### Références citées

[1]: *"*Carbon Nanotubes - Synthesis, Characterization, Applications" Edited by Dr. Siva Yellampalli July 20, 2011;
[2]: Sookhyun Hwang et al. « Effect of a Titanium Underlayer on the Ohmic Contact of Single-Walled Carbon Nanotubes » Chinese Journal of Physics 49, 1102 (2011);
[3]: Yu Zhu, et al. « A seamless three-dimensional carbon nanotube graphene hybrid material », Nature Communications 3, 1225 (2012);
[4]: Lance Delzeit et al. « Multiwalled Carbon Nanotubes by Chemical Vapor Deposition Using Multilayered Metal catalysts » J. Phys. Chem. B 2002, 106, 5629-5635.

## Revendications

1. Substrat (1) électriquement conducteur sur au moins une de ses faces, muni d'un empilement de couches minces comportant au moins une couche de matériau catalyseur adapté pour accélérer la croissance des nanotubes de carbone, **caractérisé en ce que** l'empilement comporte la séquence de couches minces déposées dans l'ordre suivant au-dessus de ladite au moins une face électriquement conductrice du substrat :
a/ le cas échéant, couche (2) métallique en métal M ou couche en alliage métallique à base du métal M ou couche en graphène;
b/ couche (3) de titane (Ti) ;
c/ couche (4) d'aluminium (Al) ;
d/ couche (5) de matériau(x) catalyseur(s) de la croissance de nanotubes de carbone.

2. Substrat (1) selon la revendication 1, étant un substrat métallique massif, le métal du substrat étant de préférence choisi parmi le cuivre (Cu), l'aluminium (Al), l'acier inoxydable, le nickel (Ni), le platine (Pt).

3. Substrat selon la revendication 1, étant un substrat revêtu d'une ou plusieurs couches minces électriquement conductrices formant ladite face électro-conductrice, la(les) couche(s) mince(s) électriquement conductrice(s) étant de préférence choisie(s) parmi le nitrure de Titane (TiN), le nitrure de tantale (TaN), le graphène" le substrat étant de préférence électriquement isolant, tel qu'en silicium (Si) ou en dioxyde de silicium (SiO2).

4. Substrat selon l'une des revendications précédentes, le métal M de la couche métallique (2) déposée directement sur la face électriquement conductrice du substrat étant choisi parmi le fer (Fe), le chrome (Cr), le nickel (Ni), le cobalt (Co), le palladium (Pd), ainsi que parmi tous les alliages binaires, ternaires ou quaternaires entre ces métaux.

5. Substrat selon l'une des revendications précédentes, le(s) matériau(x) catalyseur(s) de la croissance des nanotubes de carbone (NTC) de la couche (5) du dessus de l'empilement étant choisi(s) parmi le fer (Fe), le chrome (Cr), le nickel (Ni), le cobalt (Co), le palladium (Pd), ainsi que parmi tous les alliages binaires, ternaires ou quaternaires entre ces métaux.

6. Substrat selon l'une quelconque des revendications précédentes, la couche (2) déposée directement sur la face électriquement conductrice du substrat et la couche (5) de matériau catalyseur de la croissance de nanotubes de carbone étant constituées du même matériau.

7. Substrat selon l'une quelconque des revendications précédentes, l'épaisseur de la couche (2) déposée directement sur la face électriquement conductrice du substrat étant comprise entre 1 et 20 nm.

8. Substrat selon l'une quelconque des revendications précédentes, l'épaisseur de la couche (3) de Ti étant comprise entre 2 et 10 nm.

9. Substrat selon l'une quelconque des revendications précédentes, l'épaisseur de la couche (4) d'Al étant comprise entre 2 et 10 nm.

10. Substrat selon l'une quelconque des revendications précédentes, l'épaisseur de la couche (5) de matériau(x) catalyseur(s) de la croissance de nanotubes de carbone étant comprise entre 0,2 et 5 nm, de préférence entre 0,25 et 2 nm.

11. Substrat selon l'une quelconque des revendications 1 à 2, ou 4 à 10, l'empilement étant le suivant : substrat (1) massif en cuivre ou en aluminium/Fe/Ti/Al/Fe, la couche (2) de fer (Fe) directement en contact avec le substrat massif étant d'épaisseur comprise entre 1 et 10 nm.

12. Substrat selon l'une quelconque des revendications 1 à 2, ou 4 à 10, l'empilement étant le suivant : substrat (1) massif en acier inoxydable/Ti/Al/Fe.

13. Substrat selon l'une quelconque des revendications 1 ou 3 à 10, l'empilement étant le suivant : substrat (1) en nitrure de titane (TiN) ou nitrure de tantale (TaN) sous forme de couches minces/Fe/Ti/Al/Fe, la couche (2) de fer (Fe) directement en contact avec le substrat étant d'épaisseur comprise entre 10 et 20 nm.

14. Substrat selon l'une quelconque des revendications 1 à 2 ou 3 à 10, l'empilement étant le suivant : substrat (1) massif recouvert d'une ou plusieurs couches en graphène/Fe/Ti/Al/Fe, la couche (2) de fer (Fe) directement en contact avec le graphène étant d'épaisseur comprise entre 1 et 10 nm.

15. Substrat fonctionnel (6) comportant un substrat selon l'une quelconque des revendications précédentes revêtu d'un tapis de nanotubes de carbone (NTC), la densité de NTC étant de préférence supérieure à 10¹²/cm², voire 10¹³/cm².

16. Procédé de réalisation d'un substrat fonctionnel (6) selon la revendication 15, selon lequel on réalise les étapes suivantes :
- réalisation de l'empilement de couches minces (3, 4, 5), avec le cas échéant la couche métallique en métal M ou couche en alliage métallique à base du métal M ou couche en graphène (2), sur la face électriquement conductrice du substrat (1) selon l'une des revendications 1 à 17 par évaporation sous vide ;
- croissance de tapis de nanotubes de carbone (NTC) sur l'empilement selon une technique de dépôt chimique en phase vapeur (acronyme anglais CVD de « *Chemical Vapor Deposition* »), assistée ou non par plasma et activée par filaments chauds (acronyme anglais HFCVD pour « *Hot Wire CVD* ») ou non.
selon lequel de préférence, avant d'effectuer l'étape de croissance, on effectue une oxydation de la couche (5) de matériau(x) catalyseur(s) au moyen d'un plasma d'air.

17. Utilisation d'un substrat fonctionnel (6) selon la revendication 15 en tant qu'élément d'interconnexion en microélectronique, ou d'électrodes pour piles ou batteries, telles que des batteries au lithium-soufre, ou de supercondensateurs, d'interposeurs utilisés pour le management thermique en microélectronique, ou d'échangeurs thermiques.

## Patentansprüche

1. Substrat (1), das auf mindestens einer seiner Oberflächen elektrisch leitend ist, mit einem Stapel von Dünnschichten, die wenigstens eine Schicht aus einem Katalysatormaterial umfassen, das dazu ausgebildet ist, das Wachstum von Kohlenstoffnanoröhren zu beschleunigen, **dadurch gekennzeichnet, dass** der Stapel die Sequenz von Dünnschichten aufweist, die in der folgenden Reihenfolge über der genannten wenigstens einen elektrisch leitenden Seite des Substrats abgelegt sind:
a/ gegebenenfalls eine Schicht (2) aus Metall M oder eine Schicht aus Metalllegierung auf der Basis des Metalls M oder eine Schicht aus Graphen,
b/ eine Schicht (3) aus Titan (Ti)
c/ eine Schicht (4) aus Aluminium (Al),
d/ eine Schicht (5) aus einem oder mehreren Katalysatormaterialien für das Wachstum der Kohlenstoffnanoröhren.

2. Substrat (1) nach Anspruch 1, bei dem es sich um ein massives Metallsubstrat handelt, wobei das Metall des Substrats vorzugsweise ausgewählt ist unter Kupfer (Cu), Aluminium (Al), rostfreiem Stahl, Nickel (Ni), Platin (Pt).

3. Substrat nach Anspruch 1, bei dem es sich um ein Substrat handelt, das mit einer oder mehreren elektrisch leitenden Dünnschichten bedeckt ist, die die genannte elektrisch leitende Oberfläche bilden, wobei die elektrisch leitende Dünnschicht oder die elektrisch leitenden Dünnschichten vorzugsweise ausgewählt sind unter Titannitrid (TiN), Tantalnitrid (TaN), Graphen, wobei das Substrat vorzugsweise elektrisch isolierend ist, etwa Silizium (Si) oder Siliziumdioxid (SiO₂).

4. Substrat nach einem der vorstehenden Ansprüche, bei dem das Metall M der metallischen Schicht (2), die direkt auf der elektrisch leitenden Fläche des Substrats abgelegt ist, ausgewählt ist unter Eisen (Fe), Chrom (Cr), Nickel (Ni), Kobalt (Co), Paladium (Pd) sowie unter allen binären, ternären oder quaternären Legierungen dieser Metalle.

5. Substrat nach einem der vorstehenden Ansprüche, bei der das Katalysatormaterial oder die Katalysatormaterialien für das Wachstum der Kohlenstoffnanoröhren (NTC) der Schicht (5) auf der Oberseite des Stapels ausgewählt sind unter Eisen (Fe), Chrom (Cr), Nickel (Ni), Kobalt (Co), Paladium (Pd) sowie unter allen binären, ternären oder quaternären Legierungen dieser Metalle.

6. Substrat nach einem der vorstehenden Ansprüche, bei dem die Schicht (2), die direkt auf der elektrisch leitenden Seite des Substrats abgelegt ist, und die Schicht (5) aus dem Katalysatormaterial für das Wachstum der Kohlenstoffnanoröhren durch das gleiche Material gebildet werden.

7. Substrat nach einem der vorstehenden Ansprüche, bei der die Dicke der Schicht (2), die direkt auf der elektrisch leitenden Fläche des Substrats abgelegt ist, zwischen 1 und 20 nm beträgt.

8. Substrat nach einem der vorstehenden Ansprüche, bei dem die Dicke der Schicht (3) aus Ti zwischen 2 und 10 nm beträgt.

9. Substrat nach einem der vorstehenden Ansprüche, bei dem die Dicke der Schicht (4) aus Al zwischen 2 und 10 nm beträgt.

10. Substrat nach einem der vorstehenden Ansprüche, bei dem die Dicke der Schicht (5) aus dem Katalysatormaterial oder den Katalysatormaterialien für das Wachstum der Kohlenstoffnanoröhren zwischen 0,2 und 5 nm, vorzugsweise zwischen 0,25 und 2 nm beträgt.

11. Substrat nach einem der Ansprüche 1 bis 2 oder 4 bis 10, bei dem die Stapelung wie folgt ist: massives Substrat (1) aus Kupfer oder Aluminium/Fe/Ti/Al/Fe, wobei die Schicht (2) aus Eisen (Fe) in direktem Kontakt mit dem massiven Substrat eine Dicke zwischen 1 und 10 nm hat.

12. Substrat nach einem der Ansprüche 1 bis 2 oder 4 bis 10, bei dem die Stapelung die folgende ist: massives Substrat (1) aus rostfreiem Stahl/Ti/Al/Fe.

13. Substrat nach einem der Ansprüche 1 oder 3 bis 10, bei dem die Stapelung wie folgt ist: Substrat (1) aus Titannitrid (TiN) oder Tantalnitrid (TaN) in der Form von Dünnschichten/Fe/Ti/Al/Fe, wobei die Schicht (2) aus Eisen (Fe) in direktem Kontakt mit dem Substrat eine Dicke zwischen 10 und 20 nm hat.

14. Substrat nach einem der Ansprüche 1 bis 2 oder 3 bis 10, bei dem die Stapelung die folgende ist: massives Substrat (1) bedeckt mit einer oder mehreren Schichten aus Graphen/Fe/Ti/Al/Fe, wobei die Schicht (2) aus Eisen (Fe) in direktem Kontakt mit dem Graphen eine Dicke zwischen 1 und 10 nm hat.

15. Funktionelles Substrat (6) mit einem Substrat nach einem der vorstehenden Ansprüche, bedeckt mit einem Teppich aus Kohlenstoffnanoröhren (NTC), wobei die Dichte des NTC vorzugsweise größer als 10¹²/cm², insbesondere 10¹³/cm² ist.

16. Verfahren zur Herstellung eines funktionellen Substrats (6) nach Anspruch 15, mit den folgenden Schritten:
- Ausbilden des Stapels der Dünnschichten (3, 4, 5), gegebenenfalls mit der Schicht aus Metall M oder der Schicht aus der Metalllegierung auf der Basis des Metalls M oder der Schicht (2) aus Graphen, auf der elektrisch leitenden Oberfläche des Substrats (1) gemäß einem der Ansprüche 1 bis 17 durch Vakuumbedampfung;
- Aufwachsen des Teppichs aus Kohlenstoffnanoröhren (NTC) auf den Stapel mit einer Technik der chemischen Abscheidung aus der Dampfphase (englisches Akronym CVD für "Chemical Vapor Deposition"), unterstützt durch ein Plasma oder nicht, und aktiviert durch heiße Filamente (englisches Akronym HFCVD für "Hot Wire CVD") oder nicht,
wobei vorzugsweise vor dem Wachstumsschritt eine Oxidation der Schicht (5) aus dem Katalysatormaterial oder Katalysatormaterialien mit Hilfe eines Luftplasmas bewirkt wird.

17. Verwendung eines funktionellen Substrats (6) nach Anspruch 15 als mikroelektronisches Verbindungselement oder Elektroden für Säulen oder Batterien wie etwa Lithium-Schwefel-Batterien, oder als Superkondensatoren, als Zwischenelemente für das Temperaturmanagement in der Mikroelektronik oder als Wärmeaustauscher.

## Claims

1. A substrate (1) which is electrically conducting on at least one of its faces, provided with a stack of thin layers comprising at least one layer of catalyst material appropriate for accelerating the growth of carbon nanotubes, **characterized in that** the stack comprises the sequence of thin layers deposited in the following order above said at least one electrically conducting face of the substrate:
a/ if appropriate, metal layer (2) made of metal M or layer made of metal alloy based on the metal M or layer made of graphene;
b/ titanium (Ti) layer (3);
c/ aluminum (Al) layer (4);
d/ layer (5) of material(s) which is(are) catalyst(s) of the growth of carbon nanotubes.

2. The substrate (1) as claimed in claim 1, being a bulk metal substrate, the metal of the substrate being preferably chosen from copper (Cu), aluminum (Al), stainless steel, nickel (Ni) or platinum (Pt).

3. The substrate as claimed in claim 1, being a substrate coated with one or more thin electrically conducting layers forming said electrically conducting face, the thin electrically conducting layer(s) being preferably chosen from titanium nitride (TiN), tantalum nitride (TaN) or graphene, the substrate being preferably an electrically insulating substrate, such as a substrate made of silicon (Si) or made of silicon dioxide (SiO₂).

4. The substrate as claimed in one of the preceding claims, the metal M of the metal layer (2) deposited directly on the electrically conducting face of the substrate being chosen from iron (Fe), chromium (Cr), nickel (Ni), cobalt (Co) or palladium (Pd), and also from all the binary, ternary or quaternary alloys between these metals.

5. The substrate as claimed in one of the preceding claims, the material(s) which is(are) catalyst(s) of the growth of the carbon nanotubes (CNTs) of the layer (5) of the top of the stack being chosen from iron (Fe), chromium (Cr), nickel (Ni), cobalt (Co) or palladium (Pd), and also from all the binary, ternary or quaternary alloys between these metals.

6. The substrate as claimed in any one of the preceding claims, the layer (2) deposited directly on the electrically conducting face of the substrate and the layer (5) of material which is a catalyst of the growth of carbon nanotubes being composed of the same material.

7. The substrate as claimed in any one of the preceding claims, the thickness of the layer (2) deposited directly on the electrically conducting face of the substrate being between 1 and 20 nm.

8. The substrate as claimed in any one of the preceding claims, the thickness of the Ti layer (3) being between 2 and 10 nm.

9. The substrate as claimed in any one of the preceding claims, the thickness of the A1 layer (4) being between 2 and 10 nm.

10. The substrate as claimed in any one of the preceding claims, the thickness of the layer (5) of material(s) which is(are) catalyst(s) of the growth of carbon nanotubes being between 0.2 and 5 nm, preferably between 0.25 and 2 nm.

11. The substrate as claimed in any one of claims 1 to 2 or 4 to 10, the stack being as follows: bulk substrate (1) made of copper or of aluminum/Fe/Ti/Al/Fe, the iron (Fe) layer (2) directly in contact with the bulk substrate having a thickness of between 1 and 10 nm.

12. The substrate as claimed in any one of claims 1 to 2 or 4 to 10, the stack being as follows: bulk substrate (1) made of stainless steel/Ti/Al/Fe.

13. The substrate as claimed in any one of claims 1 or 3 to 10, the stack being as follows: substrate (1) made of titanium nitride (TiN) or tantalum nitride (TaN) in the form of thin layers/Fe/Ti/Al/Fe, the iron (Fe) layer (2) directly in contact with the substrate having a thickness of between 10 and 20 nm.

14. The substrate as claimed in any one of claims 1 to 2 or 4 to 10, the stack being as follows: bulk substrate (1) covered with one or more layers made of graphene/Fe/Ti/Al/Fe, the iron (Fe) layer (2) directly in contact with the graphene having a thickness of between 1 and 10 nm.

15. A functional substrate (6) comprising a substrate as claimed in any one of the preceding claims coated with a mat of carbon nanotubes (CNTs), the CNTs density being preferably greater than 10¹²/cm², indeed even 10¹³/cm².

16. A process for the preparation of a functional substrate (6) as claimed in claim 15, according to which the following stages are carried out:
- preparation, by vacuum evaporation, of the stack of thin layers (3, 4, 5), if appropriate with the metal layer made of metal M or layer made of metal alloy based on the metal M or layer made of graphene (2), on the electrically conducting face of the substrate (1) as claimed in one of claims 1 to 15;
- growth of mat of carbon nanotubes (CNTs) on the stack according to a chemical vapor deposition (CVD) technique, enhanced or not enhanced by plasma and activated or non activated by hot wires (Hot Wire CVD or HWCVD).
according to which, preferably, before carrying out the growth stage, the layer (5) of catalyst material(s) is oxidized by means of an air plasma.

17. The use of a functional substrate (6) as claimed in claim 15 as element of interconnections in microelectronics, or of electrodes for batteries, such as lithium-sulfur batteries, or of supercapacitors, of interposers used for thermal management in microelectronics, or of heat exchangers.
